# EUROPÄISCHE PATENTSCHRIFT

(11) **EP 1 070 392 B1**
(45) Veröffentlichungstag und Bekanntmachung des Hinweises auf die Patenterteilung: **03.07.2002**
(21) Anmeldenummer: 99913105.5
(22) Anmeldetag: 03.03.1999
(51) Int. Cl.: H03K 17/693, H04B 1/44, H04B 7/02

(54) **INTEGRIERTER SCHALTKREIS FÜR MOBILFUNK- UND MOBILTELEFONANLAGEN**
INTEGRATED CIRCUIT FOR MOBILE RADIO AND MOBILE TELEPHONE INSTALLATIONS
CIRCUIT INTEGRE DESTINE A DES INSTALLATIONS EMETTEURS-RECEPTEURS MOBILES ET DES INSTALLATIONS DE TELEPHONIE MOBILE

(30) Priorität: 11.03.1998 DE 19810557
(43) Veröffentlichungstag der Anmeldung: 24.01.2001
(73) Patentinhaber: Infineon Technologies AG, 81669 München (DE)
(72) Erfinder: GERLACH, Udo, D-81547 München (DE); WEISGERBER, Andreas, D-81669 München (DE)
(74) Vertreter: Ginzel, Christian
(86) Internationale Anmeldenummer: DE9900571
(87) Internationale Veröffentlichungsnummer: WO9946859

(56) Entgegenhaltungen:
- EP-A- 0 744 831
- EP-A- 0 751 631
- US-A- 5 689 818
- MIYATSUJI K ET AL: "A GAAS SINGLE VOLTAGE CONTROLLED RF SWITCH IC" IEICE TRANSACTIONS ON ELECTRONICS, Bd. E78-C, Nr. 8, 1. August 1995, Seiten 931-935, XP000536071
- PATENT ABSTRACTS OF JAPAN vol. 097, no. 006, 30. Juni 1997 -& JP 09 055682 A (SONY CORP), 25. Februar 1997 -& US 5 812 939 A (KOHAMA KAZUMASA) 22. September 1998

## Beschreibung

Die Erfindung betrifft eine Mikrowellenschaltungsanordnung nach Anspruch 1 und deren Verwendung in Mobiltelefonen oder Mobilfunkgeräten.

Es ist wünschenswert, Mobilfunk- und Mobiltelefonanlagen nicht nur außerhalb, sondern auch im Innern von Fahrzeugen zu betreiben. Im Inneren der Fahrzeuge werden die Sende- und Empfangsteile der Mobilfunk- und Mobiltelefonanlagen nicht mit der eingebauten Antenne, sondern mit einer am Fahrzeug angebrachten externen Antenne verbunden. Zur Umschaltung der Verbindung zwischen Sender, Empfänger, Antenne 1 (extern) und Antenne 2 (intern) werden üblicherweise innerhalb der Mobilfunk- und Mobiltelefonanlagen angeordnete Halbleiterschaltkreise eingesetzt.

In der Publikation IEEE Journal of Solid-State Circuits, Vol. 31, No. 10, Oktober 1996 ist eine Antennenumschaltung für Mikrowellen mit hoher Leistung beschrieben. Die Anordnung, welche monolithisch mit Hilfe von GaAs JFET-Halbleiterschaltelementen aufgebaut ist, ermöglicht die Verbindung eines Senders (Tₓ) mit einer externen Antennen und einer internen Antenne, bzw. die Verbindung eines Empfängers (Rₓ) mit einer dieser Antennen. Bei der beschriebenen Schaltanordnung sind zwei Zustände schaltbar, bei denen jeweils ein Eingang mit einem Ausgang verbunden ist. Ist beispielsweise die im Gerät eingebaute interne Antenne mit dem Empfänger verbunden, ist die externe Antenne mit dem Sender verbunden. Im zweiten Schaltzustand ist die eingebaute Antenne mit dem Sender verbunden und die externe Antenne mit dem Empfänger. Zur Steuerung dieser beiden Zustände werden zwei Eingangssignale benötigt (2 Bit).

Aufgabe der vorliegenden Erfindung ist es, eine Schaltungsanordnung zur Antennenumschaltung zur Verfügung zu stellen, die eine Umschaltung zwischen Sender/Empfänger und Antenne 1/Antenne 2 ermöglicht und gleichzeitig eine Möglichkeit zur Umschaltung der Mobilfunk- und Mobiltelefonanlage zwischen zwei Frequenzbändern (z.B. zwischen GSM-Modus und PCN-Modus in Dual-Band Mobiltelefonen) bietet.

Die Erfindung betrifft eine Mikrowellenschaltungsanordnung gemäß Anspruch 1.

Eine Mikrowellen Schaltungsanordnung mit den Merkmalen gemäß Oberbegriff des Anspruches 1 ist aus dem Dokument EP-A-0 744 831 bekannt.

Die erfindungsgemäße Ansteuerung der Halbleiterschaltelemente durch Veränderung des Potentials an Drain und Source ermöglicht gegenüber einer ausschließlichen Ansteuerung durch Veränderung des Potentials an den Gates eine Reduzierung der zur Codierung der Schaltzustände benötigten Ansteuerleitungen.

Beispiele für erfindungsgemäß einsetzbare Halbleiterschaltelemente sind an sich bekannte Feldeffekttransistoren, wie MESFET's, JFET's oder MOSFET's. Bevorzugt sind solche Typen, die zur Schaltung von hohen Leistungen geeignet sind. Die Steuerspannung der Halbleiterschaltelemente liegt vorteilhafterweise im Bereich von weniger als 5 V, insbesondere bei 3 V.

Es ist möglich, daß die erfindungsgemäße Schaltung aus diskreten Bauelementen aufgebaut ist. Vorzugsweise sind jedoch sämtliche Halbleiterschaltelemente, beispielsweise in Form eines Monolythic Microwave Circuits (MMIC) auf einer Schaltung integriert. Die Chipfläche, auf die die erfindungsgemäße Schaltung aufgebracht sein kann, ist vorzugsweise kleiner als 1200 x 1200 µm². Besonders bevorzugt ist es, wenn die Chipfläche kleiner als 800 x 800 µm² ist.

Die integrierte Schaltung ist vorzugsweise in einem Chipträgergehäuse untergebracht. Die Anschlüsse können dann auf übliche Weise über Bondierung nach außen geführt werden.

Die Ansteuerung der Schaltelemente in der Schaltung durch Potentialänderung kann mittels Steuerleitungen erfolgen. Wird mit einer Steuerleitung eine bestimmte Funktion geschaltet, sind keine zusätzlichen Schaltungsteile mit einer zusätzlichen Codierlogik notwendig. Es ist daher bevorzugt, daß in der Schaltungsanordnung gemäß der Erfindung keine hybrid aufgebauten Schaltungsteile vorhanden sind.

Vorzugsweise wird die erfindungsgemäße Schaltung mit einer Betriebsspannung betrieben. Das heißt, daß an der Schaltung nur eine Betriebs- bzw. Versorgungsspannung mit einem konstanten Wert anliegt. Es werden keine zusätzlichen Versorgungsspannungen benötigt.

Die Schaltung gemäß der Erfindung kann ganz allgemein zur Umschaltung zwischen Signalquellen im Mikrowellenbereich (Vorzugsweise 500 bis 2500 MHz) eingesetzt werden. Bevorzugt ist es allerdings, daß die erfindungsgemäße Schaltung mit mindestens zwei Sendevorrichtungen und mindestens zwei Empfangsvorrichtungen verbunden ist.

Die erfindungsgemäße Schaltung läßt sich zur Antennenumschaltung in Dual-Band Mobiltelefonen mit je zwei Sende- und Empfangsteilen einsetzen. Es ist somit bevorzugt, daß die Schaltung mit zwei oder mehreren Sendern und mit zwei oder mehreren Empfängern verbunden ist, wobei jeweils die Sender bzw. Empfänger sich dadurch unterscheiden, daß sie auf unterschiedlichen Frequenzbändern arbeiten.

Die erfindungsgemäße Schaltung läßt sich zur Umschaltung zwischen Sendern und Empfängern auf eine Antenne nutzen. Es ist bevorzugt, daß die Schaltung mit mindestens zwei Antennen verbunden ist.

Eine weitere Möglichkeit ist die Umschaltung zwischen einer internen und externen Antenne. Die erfindungsgemäße Schaltung ist daher vorzugsweise mit zwei oder mehrere Antennen verbunden.

Besonders bevorzugt sind durch die erfindungsgemäße Schaltung zwei Sender, zwei Empfänger und zwei Antennen miteinander verbunden.

In der erfindungsgemäßen Schaltung sind zweckmäßigerweise mindestens zwei Halbleiterschaltelemente vorhanden, die komplementär zueinander geschaltet werden können und wobei diese Halbleiterschaltelemente galvanisch voneinander entkoppelt sind. Vorzugsweise wird eines der beiden zueinander komplementär geschalteten Halbleiterschaltelemente durch Veränderung des Drain- und Source-Potentials gesteuert bzw. geschaltet und das andere durch Veränderung des Gate-Potentials.

Die Schaltung gemäß der Erfindung ist so beschaffen, daß keine negative Betriebs- bzw. Versorgungsspannung anliegt.

Besonders vorteilhaft läßt sich die erfindungsgemäße Schaltung als Antennenumschaltung in Mobiltelefon oder Mobilfunkgeräten einsetzen. Vorzugsweise läßt sich die Schaltung für Mobiltelefone oder Mobilfunkgeräte einsetzen, die in zwei Bändern arbeiten.

Ein weiterer Vorteil der erfindungsgemäßen Mikrowellenschaltungsanordnung ist, daß im Gegensatz zur Umschaltung mit konventionellen Schaltungsanordnungen ohne eine galvanische Entkopplung der komplementär geschalteten Halbleiterschaltelemente, mit einer geringeren Anzahl an Ansteuerleitungen gearbeitet werden kann. Es ist auch ein Vorteil, daß die Schaltung mit nur mit einer einzigen Versorgungsspannung auskommt. Darüberhinaus kann die erfindungsgemäße Schaltungsanordnung platzsparend und kostengünstig produziert werden, da keine Codierlogik für die Steuerung der Schaltzustände benötigt wird. Es ist auch von Vorteil, daß die Schaltung ohne aufwendige Hybridtechniken hergestellt werden kann.

Ein weiterer Vorteil der Erfindung ist es, daß eine Mikrowellenschaltungsanordnung zur Verfügung gestellt wird, die eine Umschaltung zwischen den Antennen und den Sendern bzw. Empfängern der jeweiligen Bänder ermöglicht, und welche nur drei Leitungen zur Ansteuerung ihrer Schaltungszustände benötigt.

Ein weiterer Vorteil ist es, daß diese Mikrowellenschaltungsanordnung mit einem geringen Schaltungsaufwand realisiert werden kann.

### Beispiel

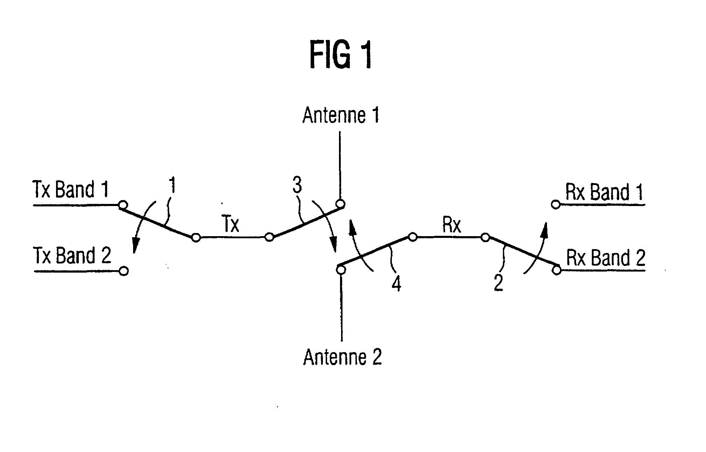

Figur 1 zeigt ein Prinzipschaltbild für eine erfindungsgemäße Antennenumschaltung. Im Schaltungszustand in Figur 1 ist ein erster Sender (Tₓ), welcher für Frequenzband 1 eingesetzt wird, mit Antenne 1 (Außenantenne) verbunden. Bei diesem Schaltungszustand ist der Empfänger (Rₓ) für Frequenzband 2 mit Antenne 2 (Innenantenne) verbunden. Im zweiten Schaltungszustand klappen die Schalter 1 und 2 um. Im dritten Schaltungszustand ändern die Schaltelemente 3 und 4 ihren Zustand.

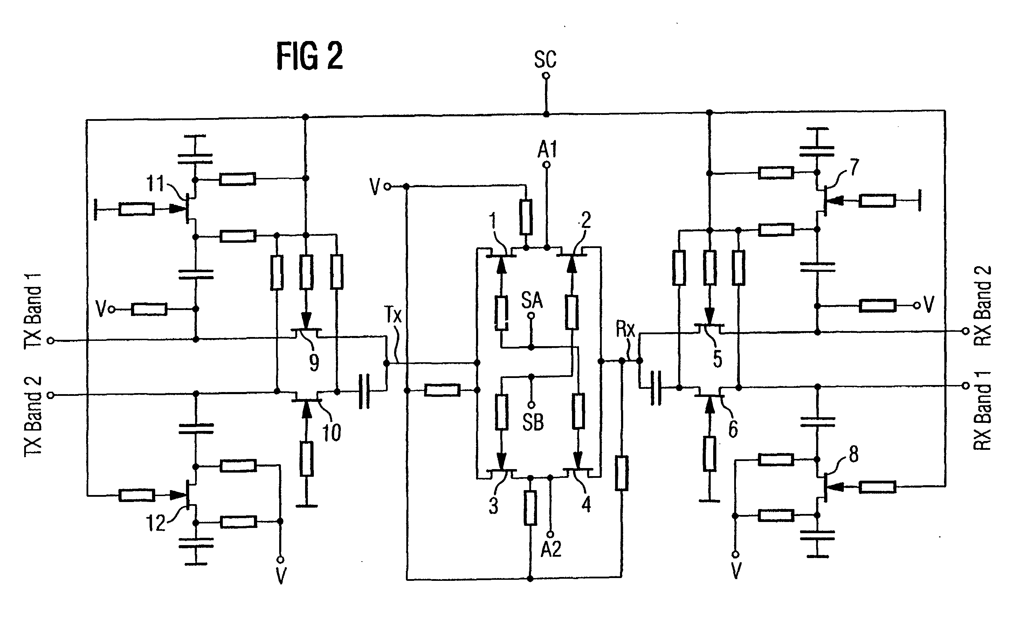

Figur 2 zeigt eine Realisierungsmöglichkeit dieses erfindungsgemäßen Schalters mit drei Steuerleitungen SA, SB und SC. Die Schaltung ist integriert monolithisch aufgebaut. Die Herstellung der Schaltung erfolgt auf an sich bekannte Weise. Die Verbindung der Antennen (A1 oder A2) mit den jeweiligen Sendern oder Empfängern wird mit MESFET-Transistoren realisiert. Die jeweils komplementär geschalteten Transistoren sind galvanisch mittels Kondensatoren entkoppelt. Die Stromversorgung erfolgt durch eine positive Versorgungsspannung V.

## Patentansprüche

1. Mikrowellenschaltungsanordnung enthaltend mehrere Halbleiterschaltelemente mit jeweils einem Drain-, Source- und Gate-Anschluß, wobei die Halbleiterschaltelemente komplementär zueinander schaltbar sind und zur Umschaltung zwischen zwei oder mehreren Antennen, zwei oder mehreren Sendern und zwei oder mehreren Empfängern dienen, wobei jeweils die Sender und Empfänger sich dadurch unterscheiden, daß sie auf unterschiedlichen Frequenzbändern arbeiten,
**dadurch gekennzeichnet, daß**
mindestens zwei Halbleiterschaltelemente galvanisch voneinander entkoppelt sind, daß eines der mindestens zwei Halbleiterschaltelemente durch Veränderung des Drain- und Source-Potentials und ein anderes durch Veränderung des Gate-Potentials gesteuert beziehungsweise geschaltet wird, daß ein erster Schalter (1), welcher mit einer ersten Klemme (Tx) verbunden ist, zwischen eine Klemme für ein erstes Sendefrequenzband (Tx Band 1) und eine Klemme für ein zweites Sendefrequenzband (Tx Band 2) umschaltet, ein zweiter Schalter (3), welcher mit der ersten Klemme (Tx) verbunden ist, zwischen eine Klemme für eine erste Antenne (Antenne 1) und eine Klemme für eine zweite Antenne (Antenne 2) umschaltet, ein dritter Schalter (4), welcher mit einer zweiten Klemme (Rx) verbunden ist, zwischen die Klemme für die zweite Antenne (Antenne 2) und die Klemme für die erste Antenne (Antenne 1) umschaltet, wobei die zweiten und dritten Schalter (3, 4) jeweils mit unterschiedlichen Antennen verbunden sind, und die zweite Klemme (Rx) mit einem vierten Schalter (2) verbunden ist, welcher zwischen eine Klemme für ein erstes Empfangsfrequenzband (Rx Band 1) und eine Klemme für ein zweites Empfangsfrequenzband (Rx Band 2) umschaltet, und daß die Schaltungsanordnung drei Schaltungszustände hat, wobei im ersten Schaltungszustand der erste Schalter (1) mit der Klemme für das erste Sendefrequenzband (Tx Band 1) verbunden ist, der zweite Schalter (3) mit der Klemme für die erste Antenne (Antenne 1), der dritte Schalter (4) mit der Klemme für die zweite Antenne (Antenne 2) und der vierte Schalter (2) mit der Klemme für das zweite Empfangsband (Rx Band 2), im zweiten Schaltungszustand der erste Schalter (1) mit der Klemme für das zweite Sendefrequenzband (Tx Band 2) der vierte Schalter (2) mit der Klemme für das erste Empfangsfrequenzband (Rx Band 1), der zweite Schalter (3) mit der Klemme für die erste Antenne (Antenne 1) und der dritte Schalter (4) mit der Klemme für die zweite Antenne (Antenne 2) verbunden ist und im dritten Schaltungszustand der erste Schalter (1) mit der Klemme für das zweite Sendefrequenzband (Tx Band 2), der vierte Schalter (2) mit der Klemme für das erste Empfangsfrequenzband (Rx Band 1), der zweite Schalter (3) mit der Klemme für die zweite Antenne (Antenne 2) und der dritte Schalter (4) mit der Klemme für die erste Antenne (Antenne 1) verbunden ist.

2. Schaltungsanordnung nach Anspruch 1,
**dadurch gekennzeichnet, daß**
sämtliche Halbleiterschaltelemente auf einer Schaltung integriert sind.

3. Schaltungsanordnung nach Anspruch 1 oder 2,
**dadurch gekennzeichnet, daß**
keine hybrid aufgebauten Schaltungsteile vorhanden sind.

4. Schaltungsanordnung nach mindestens einem der Ansprüche 1 bis 3,
**dadurch gekennzeichnet, daß**
die Schaltungsanordnung mit einer Betriebsspannung betrieben wird.

5. Schaltungsanordnung nach mindestens einem der Ansprüche 1 bis 4,
**dadurch gekennzeichnet, daß**
die möglichen Schaltungszustände mit drei binären Steuerleitungen eingestellt werden.

6. Schaltungsanordnung nach mindestens einem der Ansprüche 1 bis 5,
**dadurch gekennzeichnet, daß**
nur eine Betriebs- bzw. Versorgungsspannung mit einem konstantem Wert anliegt.

7. Verwendung der Schaltungsanordnung nach mindestens einem der Ansprüche 1 bis 6 in Mobiltelefonen oder Mobilfunkgeräten.

## Claims

1. Microwave circuit arrangement containing a plurality of semiconductor switching elements each having a drain connection, source connection and gate connection, in which case the semiconductor switching elements can be switched complementarily with respect to one another and two or more transmitters and two or more receivers serve for the changeover between two or more antennas, in which case the transmitters and receivers respectively differ in that they operate on different frequency bands,
**characterized in that**,
at least two semiconductor switching elements are directly electrically decoupled from one another, **in that** one of the at least two semiconductor switching elements is controlled or switched by alteration of the drain and source potentials, and another by alteration of the gate potential, **in that** a first switch (1), which is connected to a first terminal (Tx), changes over between a terminal for a first transmission frequency band (Tx Band 1) and a terminal for a second transmission frequency band (Tx Band 2), a second switch (3), which is connected to the first terminal (Tx), changes over between a terminal for a first antenna (Antenna 1) and a terminal for a second antenna (Antenna 2), a third switch (4), which is connected to a second terminal (Rx), changes over between the terminal for the second antenna (Antenna 2) and the terminal for the first antenna (Antenna 1), in which case the second and third switches (3, 4) are each connected to different antennas, and the second terminal (Rx) is connected to a fourth switch (2), which changes over between a terminal for a first reception frequency band (Rx Band 1) and a terminal for a second frequency band (Rx Band 2), and **in that** the circuit arrangement has three circuit states, in which case, in the first circuit state, the first switch (1) is connected to the terminal for the first transmission frequency band (Tx Band 1), the second switch (3) is connected to the terminal for the first antenna (Antenna 1), the third switch (4) is connected to the terminal for the second antenna (Antenna 2) and the fourth switch (2) is connected to the terminal for the second reception band (Rx Band 2), in the second circuit state, the first switch (1) is connected to the terminal for the second transmission frequency band (Tx Band 2), the fourth switch (2) is connected to the terminal for the first reception frequency band (Rx Band 1), the second switch (3) is connected to the terminal for the first antenna (Antenna 1) and the third switch (4) is connected to the terminal for the second antenna (Antenna 2), and, in the third circuit state, the first switch (1) is connected to the terminal for the second transmission frequency band (Tx Band 2), the fourth switch (2) is connected to the terminal for the first reception frequency band (Rx Band 1), the second switch (3) is connected to the terminal for the second antenna (Antenna 2) and the third switch (4) is connected to the terminal for the first antenna (Antenna 1).

2. Circuit arrangement according to Claim 1,
**characterized in that**
all of the semiconductor switching elements are integrated on a circuit.

3. Circuit arrangement according to Claim 1 or 2,
**characterized in that**
no circuit sections of hybrid construction are present.

4. Circuit arrangement according to at least one of Claims 1 to 3,
**characterized in that**
the circuit arrangement is operated with an operating voltage.

5. Circuit arrangement according to at least one of Claims 1 to 4,
**characterized in that**
the possible circuit states are set by means of three binary control lines.

6. Circuit arrangement according to at least one of Claims 1 to 5,
**characterized in that**
there is only one operating or supply voltage present, with a constant value.

7. Use of the circuit arrangement according to at least one of Claims 1 to 6 in mobile telephones or mobile radio transceivers.

## Revendications

1. Circuit hyperfréquence comprenant plusieurs éléments semi-conducteurs de commutation ayant respectivement une borne de drain, une borne de source et une borne de grille, les éléments semi-conducteurs de commutation pouvant être commutés de façon complémentaire les uns par rapport aux autres et servant à la commutation entre deux ou plusieurs antennes, deux ou plusieurs émetteurs et deux ou plusieurs récepteurs, les émetteurs et récepteurs se distinguant respectivement par le fait qu'ils travaillent sur des bandes de fréquences différentes,
**caractérisé par le fait qu'**au moins deux éléments semi-conducteurs de commutation sont découplés électriquement l'un de l'autre, l'un des au moins deux éléments semi-conducteurs de commutation est commandé ou commuté par une modification du potentiel de drain et de source et un autre par une modification du potentiel de grille, un premier commutateur (1) qui est relié à une première borne (Tx) effectue une commutation entre une borne pour une première bande de fréquences d'émission (Tx bande 1) et une borne pour une deuxième bande de fréquences d'émission (Tx bande 2), un deuxième commutateur (3) qui est relié à la première borne (Tx) effectue une commutation entre une borne pour une première antenne (antenne 1) et une borne pour une deuxième antenne (antenne 2), un troisième commutateur (4) qui est relié à une deuxième borne (Rx) effectue une commutation entre la borne pour la deuxième antenne (antenne 2) et la borne pour la première antenne (antenne 1), les deuxième et troisième commutateurs (3, 4) étant reliés chacun à des antennes différentes et la deuxième borne (Rx) étant reliée à un quatrième commutateur (2) qui effectue une commutation entre une borne pour une première bande de fréquences de réception (Rx bande 1) et une borne pour une deuxième bande de fréquences de réception (Rx bande 2), et le circuit a trois états de commutation tels que, dans le premier état de commutation, le premier commutateur (1) est relié à la borne pour la première bande de fréquences d'émission (Tx bande 1), le deuxième commutateur (3) à la borne pour la première antenne (antenne 1), le troisième commutateur (4) à la borne pour la deuxième antenne (antenne 2) et le quatrième commutateur (2) à la borne pour la deuxième bande de fréquences de réception (Rx bande 2), dans le deuxième état de commutation, le premier commutateur (1) est relié à la borne pour la deuxième bande de fréquences d'émission (Tx bande 2), le quatrième commutateur (2) à la borne pour la première bande de fréquences de réception (Rx bande 1), le deuxième commutateur (3) à la borne pour la première antenne (antenne 1) et le troisième commutateur (4) à la borne pour la deuxième antenne (antenne 2) et, dans le troisième état de commutation, le premier commutateur (1) est relié à la borne pour la deuxième bande de fréquences d'émission (Tx bande 2), le quatrième commutateur (2) à la borne pour la première bande de fréquences de réception (Rx bande 1), le deuxième commutateur (3) à la borne pour la deuxième antenne (antenne 2) et le troisième commutateur (4) à la borne pour la première antenne (antenne 1).

2. Circuit selon la revendication 1,
**caractérisé par le fait que** tous les éléments semi-conducteurs de commutation sont intégrés sur un circuit.

3. Circuit selon la revendication 1 ou 2,
**caractérisé par le fait qu'**il n'existe aucune partie de circuit ayant une structure hybride.

4. Circuit selon au moins l'une des revendications 1 à 3,
**caractérisé par le fait que** le circuit fonctionne avec une tension de service.

5. Circuit selon au moins l'une des revendications 1 à 4,
**caractérisé par le fait que** les états de commutation possibles sont réglés avec trois lignes de commande binaires.

6. Circuit selon au moins l'une des revendications 1 à 5,
**caractérisé par le fait que** seule une tension de service ou d'alimentation avec une valeur constante est appliquée.

7. Utilisation du circuit selon au moins l'une des revendications 1 à 6 dans des installations d'émetteurs-récepteurs mobiles et de téléphones mobiles.
